# EUROPEAN PATENT APPLICATION

(11) **EP 4 780 189 A1**
(43) Date of publication of application: **22.07.2026**
(21) Application number: 25163416.8
(22) Date of filing: 13.03.2025
(51) Int. Cl.: H10P 72/30, H10P 72/00

(54) **COMMON RAIL HANDLING EQUIPMENT**

(30) Priority: 20.01.2025 TW 114102245
(71) Applicant: Sanwa Engineering Corp., Qionglin Township, Hsinchu 307409 (TW)
(72) Inventor: CHANG, Li-Ping, Qionglin Township, Hsinchu County (TW); LIN, Shu-Yu, Qionglin Township, Hsinchu County (TW); CHEN, Ling-Kun, Qionglin Township, Hsinchu County (TW); HSIAO, Ching-Yu, Qionglin Township, Hsinchu County (TW)
(74) Representative: Carstens, Dirk Wilhelm

(57) **Abstract**

A common rail handling equipment (100) including a linear guide, a platform (130), a lifting assembly, movable arms (120), and a rotation assembly (140) is provided. The linear guide includes a power and control module (CM), a rail (110) having multiple electric-magnetic coils (111), and a first, a second, a third and a fourth sliders (SL1, SL2, SL3, SL4) with fixed magnetism movably coupled to the rail (110). The electric-magnetic coils (111) are powered to generate corresponding magnetic fields to drive the first, the second, the third and the fourth sliders (SL1, SL2, SL3, SL4) to move on the rail (110) respectively. The lifting assembly (150) is connected to the second slider (SL2), the fourth slider (SL4), and the platform (130). The rotation assembly (140) is disposed to the first slider (SL1), the third slider (SL3), and the platform (130) to connect the movable arms (120).

## Description

### BACKGROUND

### Technical Field

The disclosure relates to a handling equipment, and in particular relates to a common rail handling equipment.

### Description of Related Art

Due to stringent cleanliness requirements, robotic equipment, related wafer transfer systems (equipment front end module, EFEM), and vacuum transfer platforms for semiconductor production are extensively utilized across various fields such as wafer processing, wafer fabrication facilities and photomask equipment, as well as back-end assembly, packaging, and testing operations.

Generally speaking, in the manufacturing process of semiconductor devices, the interior of the processing module containing the wafer is maintained in a depressurized (vacuum) state to facilitate various processing operations or storage of the wafer. These processing operations are performed in a substrate processing apparatus (hereinafter also referred to as a wafer processing apparatus) having multiple processing modules. The wafer processing apparatus, for example, includes: an atmospheric section, equipped with an atmospheric module for performing desired processing on wafers in an atmospheric environment; and a depressurized (vacuum) section, equipped with a depressurized (vacuum) module for processing wafers in a depressurized (vacuum) environment. The atmospheric section and the depressurized section (vacuum section) are integrally connected via a load lock module configured to switch the interior between an atmospheric environment and a depressurized (vacuum) environment. From the perspective of user requirements or the efficiency of wafer processing, in the design of wafer processing apparatus, it is sometimes required to accommodate a greater number of processing modules. In view of various challenges such as the reduction of the occupied area of wafer processing apparatus, limitations on the length of handling arms, and the enhancement of production capacity of wafer processing apparatus, there is room for further discussion on the appropriate apparatus design when adding processing modules. For example, when proposing the installation of a bus module to connect existing vacuum handling modules in order to accommodate more processing modules in a vacuum handling system, issues may arise such as an increase in occupied area accompanying the installation of the bus module, or a misalignment in the notch orientation due to the reception and delivery of wafers within the bus module.

Following the aforementioned, due to constraints such as spatial limitations, production costs, and the achievable degree of vacuum, the aforementioned transfer equipment is unable to consistently attain maximum content simplification. For example, since it is relatively difficult to maintain a vacuum in a large space, a more common practice is to dispose a buffer zone between at least two sets of transfer equipment (e.g., robotic arms), that is, to achieve the purpose of transferring objects in a vacuum environment by means of robotic arm relay.

However, even if the above method is adopted, the height of the existing vacuum chamber is limited by the height of the position (platform) of the robot arm, the height of the rotation axis, the height of the arm joint, and the height of the position (platform) of the buffer zone, and therefore a large utilization (handling) space cannot be provided.

### SUMMARY

A common rail handling equipment, which has better handling efficiency and vacuum space utilization rate, is provided in the disclosure.

The common rail handling equipment of the disclosure is suitable for a vacuum environment and includes a linear guide, a platform, a lifting assembly, a movable arm, and a rotation assembly. The linear guide includes a power and control module, a rail, a first slider, a second slider, a third slider, and a fourth slider. The rail includes multiple electric-magnetic coils arranged linearly and electrically connected to the power and control module respectively. The first slider, the second slider, the third slider, and the fourth slider are respectively movably coupled to the rail sequentially and respectively have fixed magnetism. The electric-magnetic coils electrically connected to the power and control module are powered to generate corresponding magnetic fields to drive and control the first slider, the second slider, the third slider and the fourth slider to slide on the rail respectively. The lifting assembly is connected to the second slider, the fourth slider, and the platform. The power and control module drives the second slider and the fourth slider to slide on the rail, and drives the platform to rise and lower relative to the rail through the lifting assembly. The movable arm is movably disposed on the platform. The rotation assembly is disposed on the first slider, the third slider, and the platform to connect the movable arm. The power and control module drives the first slider and the third slider to slide on the rail, and drives the movable arm to extend or retract or rotate relative to the rail through the rotation assembly.

In one embodiment of the disclosure, the rotation assembly includes a first rack and a first gear. The first rack is fixed on the first slider. The first gear is rotatably disposed on the platform, and the first rack and the first gear are on movement paths of each other.

In one embodiment of the disclosure, the rotation assembly further includes a second rack and a second gear. The second rack is fixed on the third slider. The second gear is rotatably disposed on the platform, and the second rack and the second gear are movably engaged with each other.

In one embodiment of the disclosure, the first gear and the second gear are coaxially arranged one above another.

In one embodiment of the disclosure, the common rail handling equipment further includes a first shaft, a second shaft, and a first rail assembly. The first shaft is assembled to the platform, and a second arm of the movable arm is connected to the first shaft. The first rail assembly is connected between the first shaft and the second shaft, and the first shaft is lifted and lowered relative to the second shaft through the first rail assembly.

In one embodiment of the disclosure, the first gear surrounds the first shaft and the second shaft, and the second gear and the second shaft are an integrated structure, so that when the second gear rotates, the second arm is driven to rotate through the second shaft, the first rail assembly, and the first shaft.

In one embodiment of the disclosure, the first gear has a tooth portion that is a ring shape and a driving protrusion extending from a top surface of the ring shape. The movable arm includes a first arm, pivotally disposed on the platform. The first arm has a first arm portion and a driven protrusion extending from a bottom surface of the first arm portion, and the driven protrusion passes through the platform and extends to a rotation path of the driving protrusion, so that when the first gear rotates, the first arm is driven to rotate through the driving protrusion and the driven protrusion.

In one embodiment of the disclosure, the movable arm is a scissor-type linkage mechanism, and a second arm of the movable arm is connected to and synchronized with the second gear through a shaft assembly, and the first gear is coaxially sleeved outside the shaft assembly and may rotate relative to each other. The power and control module drives the first slider and the third slider to move synchronously in different directions and at a constant speed to drive the movable arm to rotate along the axis. The power and control module drives the first slider and the third slider to move synchronously in a same direction and at a constant speed to drive the movable arm to extend or retract.

In one embodiment of the disclosure, the lifting assembly is a scissor-type linkage mechanism, one end of the scissor-type linkage mechanism is pivotally connected to the second slider, and another end of the scissor-type linkage mechanism is pivotally connected to the fourth slider. The power and control module drives the second slider and the fourth slider to move closer to each other to raise the platform, and the power and control module drives the second slider and the fourth slider to move away from each other to lower the platform.

In one embodiment of the disclosure, the first slider, the second slider, the third slider and the fourth slider are respectively permanent magnets or electromagnets.

In one embodiment of the disclosure, the first slider, the second slider, the third slider and the fourth slider are coplanar.

In one embodiment of the disclosure, the common rail handling equipment further includes a second rail assembly assembled between the lifting assembly and the platform, so that the platform may slide along the rail relative to the lifting assembly through the second rail assembly.

In one embodiment of the disclosure, the common rail handling equipment is suitable for being disposed in a vacuum chamber to form a vacuum processing system, and multiple processing stations are connected to a periphery of the vacuum chamber. A substrate in one of the processing stations is suitable for being transferred to another processing station by the common rail handling equipment.

Based on the above, the common rail handling equipment uses a linear guide as a main driving source, in which four sliders are movably disposed on the same rail. The rail includes multiple electric-magnetic coils arranged linearly, and the sliders each have fixed magnetism. The electric-magnetic coil is powered by the power and control module to generate corresponding magnetic fields, which may respectively drive these sliders of the common rail. Therefore, when the power and control module generates magnetic force through the electric-magnetic coils to drive these slides to slide on the rail, it may further achieve the action of lifting and lowering the movable arm and driving the movable arm to pick up and place the substrate through the lifting assembly or the rotation assembly. The lifting and lowering action is achieved by the second slider and the fourth slider in combination with the lifting assembly, while the rotation action is achieved by the first slider, the third slider, and the paired rotation assembly.

Through the above-mentioned four sliders driven by magnetic force, in addition to allowing the platform and the movable arm supported thereon to move along the rail, different sliders are further paired with the corresponding lifting assembly and rotation assembly, so that different movement modes of the sliders on the rail may accordingly generate various motion modes for the platform and the movable arm. In this way, the aforementioned driving components may be effectively and unobstructedly disposed in the vacuum chamber. In addition to avoiding concerns related to vacuum degree or potential contamination, this approach enables the completion of object transfer within a vacuum environment through the movement operation of a single movable arm.

### BRIEF DESCRIPTION OF THE DRAWINGS

FIG. 1 is a schematic diagram of a vacuum processing system according to an embodiment of the disclosure.
FIG. 2A is a top view of the vacuum processing system of FIG. 1.
FIG. 2B is a schematic diagram of some components of the vacuum processing system of FIG. 1.
FIG. 3A is an exploded schematic diagram of some components of FIG. 2B.
FIG. 3B illustrates some components of FIG. 3A from another perspective.
FIG. 3C is a further exploded schematic diagram of some components of FIG. 3A.
FIG. 3D is a partial cross-sectional diagram of the common rail handling equipment at the rotation assembly.
FIG. 4A to FIG. 4D illustrate different movement modes of the common rail handling equipment in simple diagrams.
FIG. 5 is an operation flowchart of the common rail handling equipment.
FIG. 6A to FIG. 6B, FIG. 7A to FIG. 7D, FIG. 8, FIG. 9A to FIG. 9B, FIG. 10A to FIG. 10B, FIG. 11A to FIG. 11B, and FIG. 12 to FIG. 13 are schematic diagrams corresponding to the process of FIG. 5 in different perspectives and different graphics.

### DETAILED DESCRIPTION OF DISCLOSED EMBODIMENTS

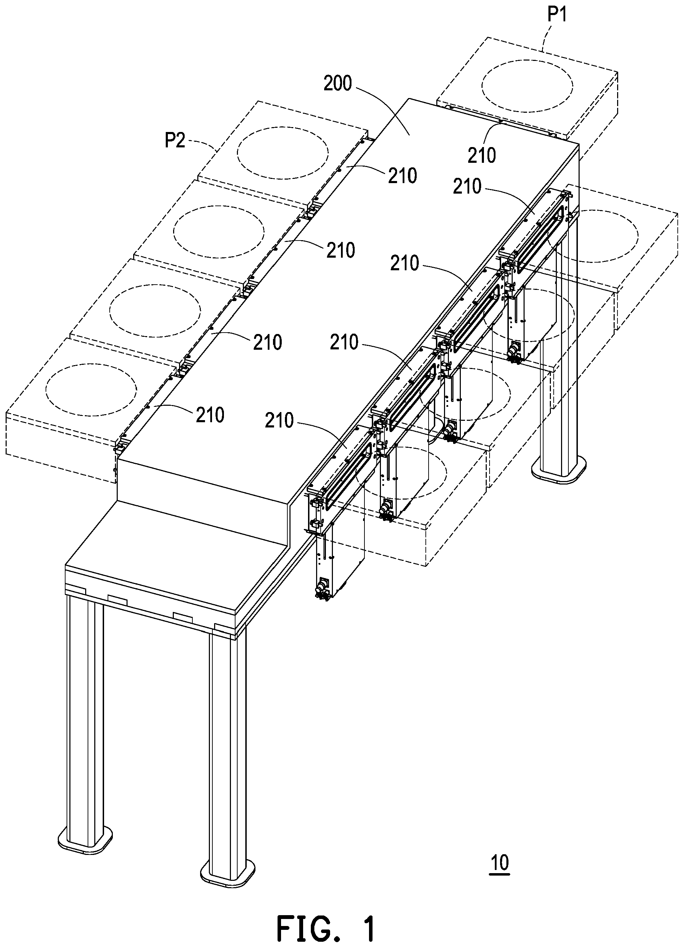

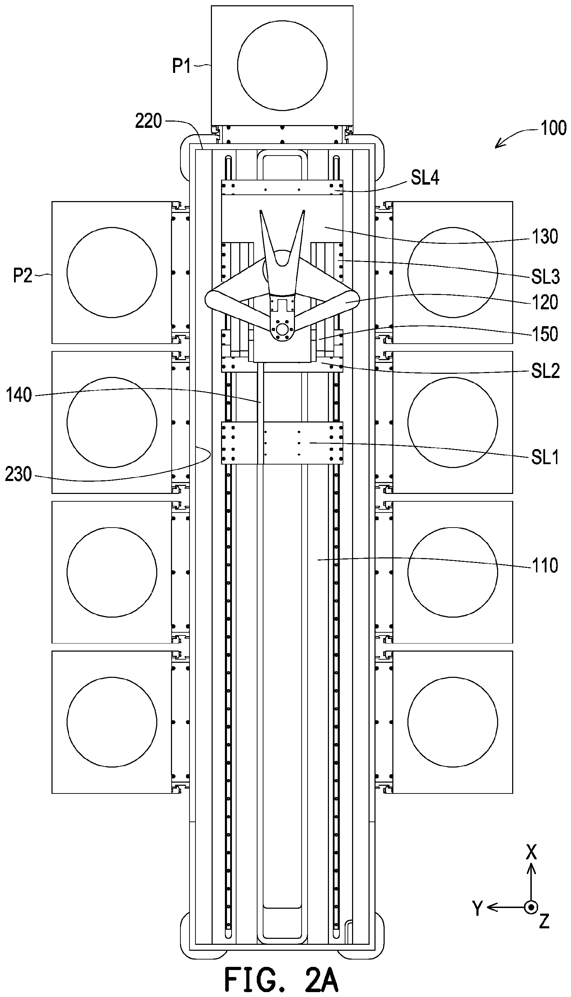

FIG. 1 is a schematic diagram of a vacuum processing system according to an embodiment of the disclosure. FIG. 2A is a top view of the vacuum processing system of FIG. 1. Referring to FIG. 1 and FIG. 2A simultaneously, in this embodiment, the vacuum processing system 10 is used to transfer substrates in a vacuum environment to effectively avoid contamination of the substrates caused by the external environment. The vacuum processing system 10 includes a common rail handling equipment 100, a vacuum chamber 200, and multiple processing stations. The common rail handling equipment 100 is disposed in the vacuum chamber 200. In addition to providing an accommodation space for the common rail handling equipment 100, the vacuum chamber 200 also includes related vacuum equipment (e.g., vacuum pumps, vacuum pipes, etc., which are configured to create a vacuum environment in the accommodation space, not shown herein) and is connected to multiple processing stations through multiple slit valves 210 to ensure a vacuum environment by opening and closing the slit valves 210. In this way, the vacuum processing system 10 may transfer substrates (e.g., the aforementioned wafers) between the processing stations through the vacuum chamber 200 and the common rail handling equipment 100 therein. As shown in FIG. 2A, the vacuum chamber 200 of this embodiment may be connected to 9 processing stations (or storage chambers), but not limited thereto. The processing stations P1 and P2 are taken as examples for subsequent explanation.

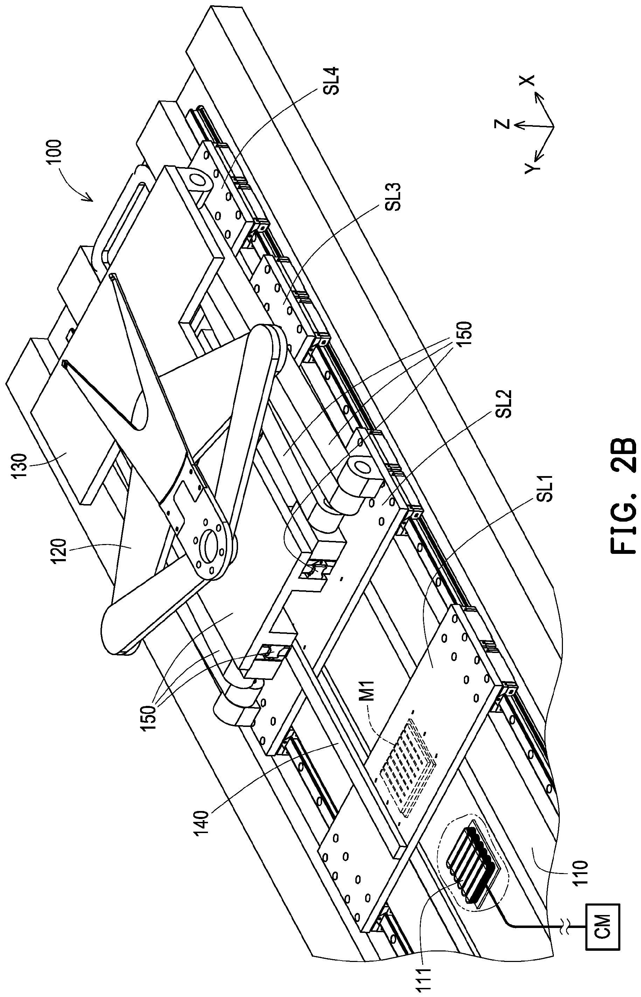

FIG. 2B is a schematic diagram of some components of the vacuum processing system of FIG. 1. Cartesian coordinates XYZ are provided here to facilitate component description. Referring to FIG. 2A and FIG. 2B simultaneously, in this embodiment, the common rail handling equipment 100 includes a linear guide, a platform 130, a lifting assembly 150, a movable arm 120, and a rotation assembly 140. The linear guide includes a power and control module CM, a rail 110, a first slider SL1, a second slider SL2, a third slider SL3, and a fourth slider SL4. The rail 110 includes multiple electric-magnetic coils 111 arranged linearly and electrically connected to the power and control module CM respectively. The first slider SL1, the second slider SL2, the third slider SL3, and the fourth slider SL4 are respectively movably coupled to the rail 110 sequentially and respectively have fixed magnetism. Here, the required fixed magnetism is achieved by disposing permanent magnets M1 in the above-mentioned sliders. In another embodiment not shown, electromagnets may be disposed in the above-mentioned sliders to generate fixed magnetism after being powered by the power and control module CM. Here, the first slider SL1, the second slider SL2, the third slider SL3, and the fourth slider SL4 are co-located on the rail 110 and may be regarded as being coplanar.

Furthermore, the electric-magnetic coil 111 electrically connected to the power and control module CM are powered to generate corresponding magnetic fields to drive and control the first slider SL1, the second slider SL2, the third slider SL3, and the fourth slider SL4 to slide along the rail 110. The lifting assembly 150 is connected to the second slider SL2, the fourth slider SL4, and the platform 130. The power and control module CM drives the second slider SL2 and the fourth slider SL4 to slide on the rail 110, and drives the platform 130 to rise and lower relative to the rail 110 along the Z-axis through the lifting assembly 150. The movable arm 120 is movably disposed on the platform 130. The rotation assembly 140 is disposed on the first slider SL1, the third slider SL3, and the platform 130 to connect the movable arm 120. The power and control module CM drives the first slider SL1 and the third slider SL3 to slide on the rail 110, and drives the movable arm 120 to extend or retract or rotate relative to the rail 110 through the rotation assembly 140.

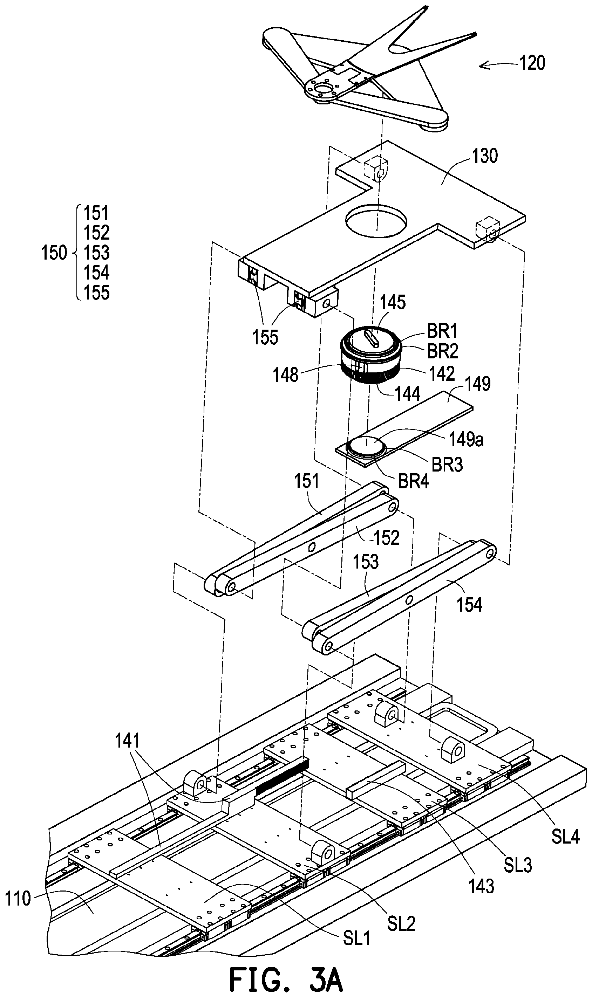

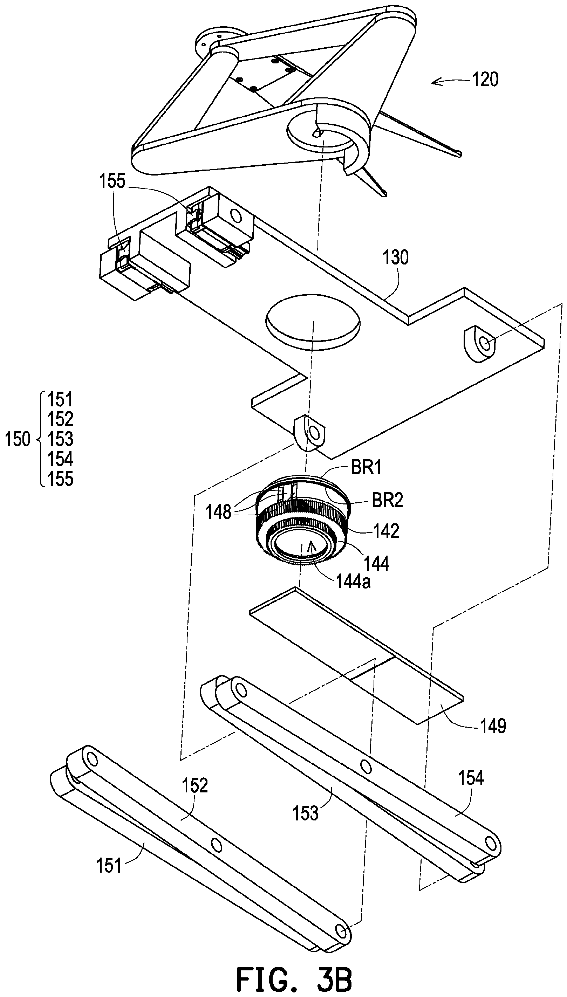

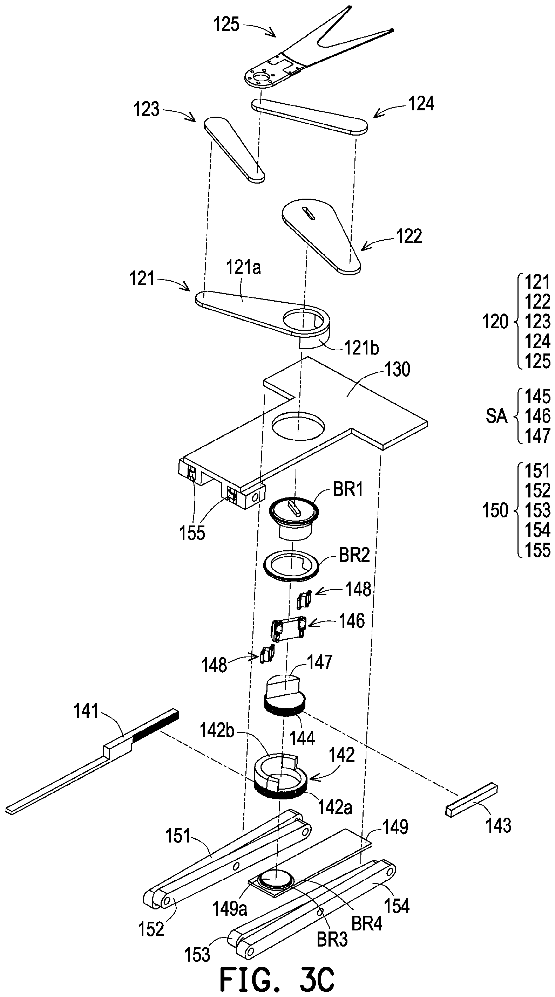

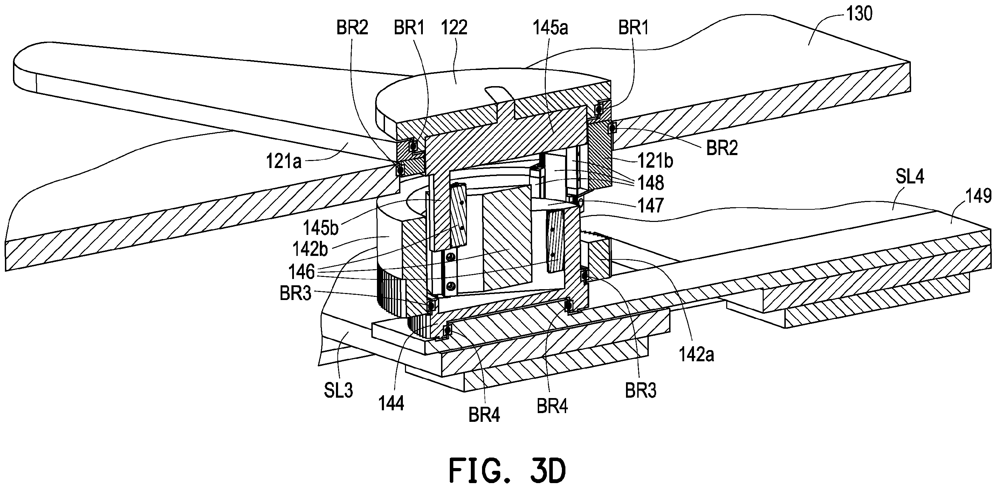

FIG. 3A is an exploded schematic diagram of some components of FIG. 2B. FIG. 3B illustrates some components of FIG. 3A from another perspective. FIG. 3C is a further exploded schematic diagram of some components of FIG. 3A. FIG. 3D is a partial cross-sectional diagram of the common rail handling equipment at the rotation assembly. Referring to FIG. 3A to FIG. 3C, in this embodiment, the rotation assembly 140 includes a first rack 141, a first gear 142, a second rack 143, and a second gear 144. The first rack 141 is fixed on the first slider SL1 and extends toward the third slider SL3. The first gear 142 is rotatably disposed on the platform 130, and the first rack 141 and the first gear 142 are on the movement paths of each other, so that when the first slider SL1 slides, the first rack 141 may movably engage with the first gear 142 to drive the first gear 142 to rotate along the Z-axis. The second rack 143 is fixed on the third slider SL3. The second gear 144 is rotatably disposed on the platform 130, and the second rack 143 and the second gear 144 are movably engaged with each other, so that the sliding action of the third slider SL3 along the X-axis on the rail 110 may be converted into the rotation action of the second gear 144 along the Z-axis.

Furthermore, referring to FIG. 3C and FIG. 3D, the rotation assembly 140 further includes a first bearing BR1, a second bearing BR2, a third bearing BR3 and a fourth bearing BR4. The first bearing BR1 is disposed between the second arm 122 and the first arm portion 121a of the first arm 121 so that they may rotate relative to each other along the Z-axis. The second bearing BR2 is disposed between the driven protrusion 121b of the first arm 121 and the platform 130 so that they may rotate relative to each other along the Z-axis. The third bearing BR3 is disposed between (the inner annular surface of) the tooth portion 142a of the first gear 142 and (the upper outer annular surface of the tooth portion of) the second gear 144 so that they may rotate relative to each other along the Z-axis. The fourth bearing BR4 is disposed between the inner annular surface of the second gear 144 and (the outer annular surface of) the seat 149a (outer ring surface) of the carrier plate 149 so that they may rotate relative to each other along the Z-axis. At the same time, the carrier plate 149 is substantially fixed on the fourth slider SL4 and extends to the top of the third slider SL3 (i.e., the carrier plate 149 does not contact the third slider SL3) to facilitate the pairing design of the rotation assembly 140 and the movable arm 120. Here, the seat 149a is a protruding structure to fit the concave structure 144a (shown in FIG. 3B and FIG. 3D) of the second gear 144.

In addition, in the common rail handling equipment 100 of this embodiment, the rotation assembly 140 further includes a shaft assembly SA, which is composed of a first shaft 145, a second shaft 147 and a first rail assembly 146. The first shaft 145 is rotatably assembled to the platform 130, and the second arm 122 of the movable arm 120 is connected to the first shaft 145. The first rail assembly 146 is connected between the first shaft 145 and the second shaft 147, and the first shaft 145 is lifted and lowered along the Z-axis relative to the second shaft 147 through the first rail assembly 146. The first gear 142 surrounds the first shaft 145 and the second shaft 147, and the second gear 144 and the second shaft 147 are an integral structure, so that when the second gear 144 rotates, the second arm 122 is driven to rotate together along the Z-axis through the second shaft 147, the first rail assembly 146, and the first shaft 145.

As shown in FIG. 3C, the first gear 142 has a tooth portion 142a that is a ring shape and a driving protrusion 142b extending from a top surface of the ring shape. The movable arm 120 further includes a first arm 121 pivotally disposed on the platform 130. The first arm 121 has a first arm portion 121a and a driven protrusion 121b extending from a bottom surface of the first arm portion 121a, and the driven protrusion 121b passes through the platform 130 and extends to a rotation path of the driving protrusion 142b, so that when the first gear 142 rotates along the Z-axis, the first arm 121 is driven to rotate together along the Z-axis through the driving protrusion 142b and the driven protrusion 121b. On the other hand, the rotation assembly 140 of this embodiment further includes a second rail assembly 148 disposed between the driven protrusion 121b and the driving protrusion 142b. The two sets of second rail assemblies 148 shown each include a pair of linear guides and a buffer block therebetween. The second rail assembly 148 enables the first arm 121 and the first gear 142 to rotate synchronously along the Z-axis, while allowing only relative movement along the Z-axis between them. The second rail assembly 148 has the same structure and purpose as the first rail assembly 146 described above.

The movable arm 120 of this embodiment further includes a third arm 123, a fourth arm 124 and a pick-and-place arm 125. The third arm 123 is pivotally connected to the first arm 121, the fourth arm 124 is pivotally connected to the second arm 122, and the third arm 123 and the fourth arm 124 are pivotally connected to each other and are also pivotally connected to the pick-and-place arm 125, thereby forming a scissor-type linkage mechanism, so as to generate extension or retraction through rotation of different directions. Further explanation is given subsequently.

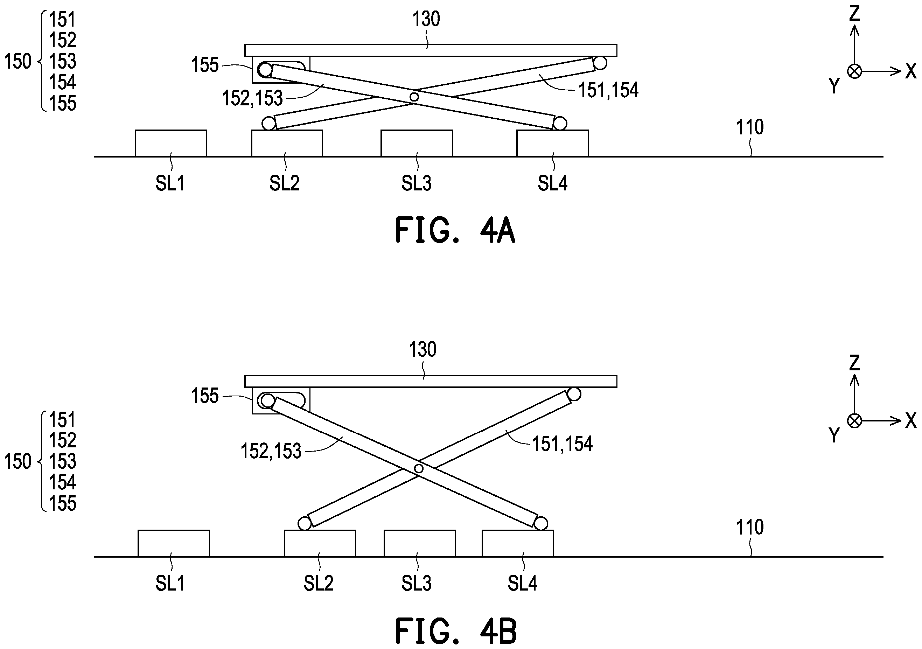

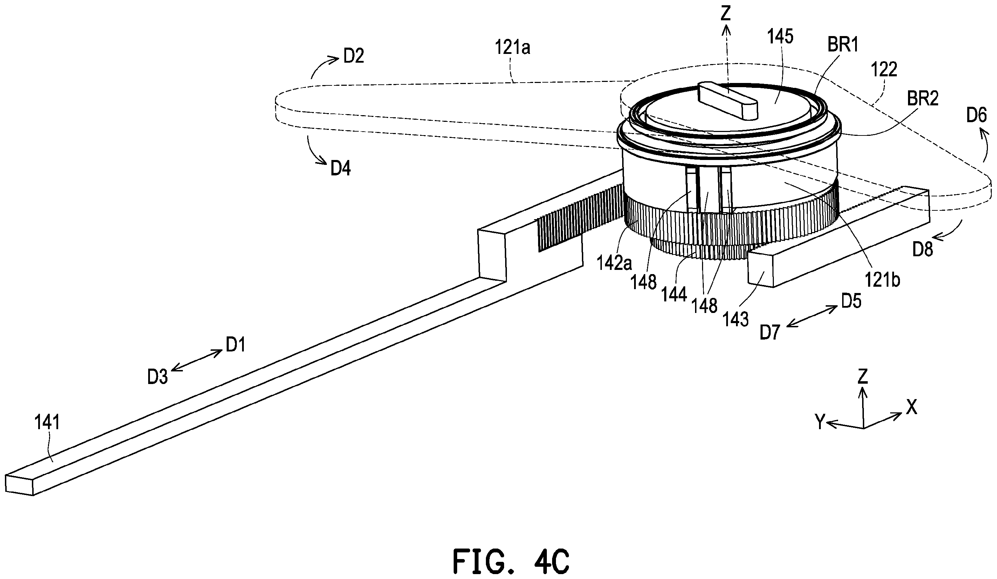

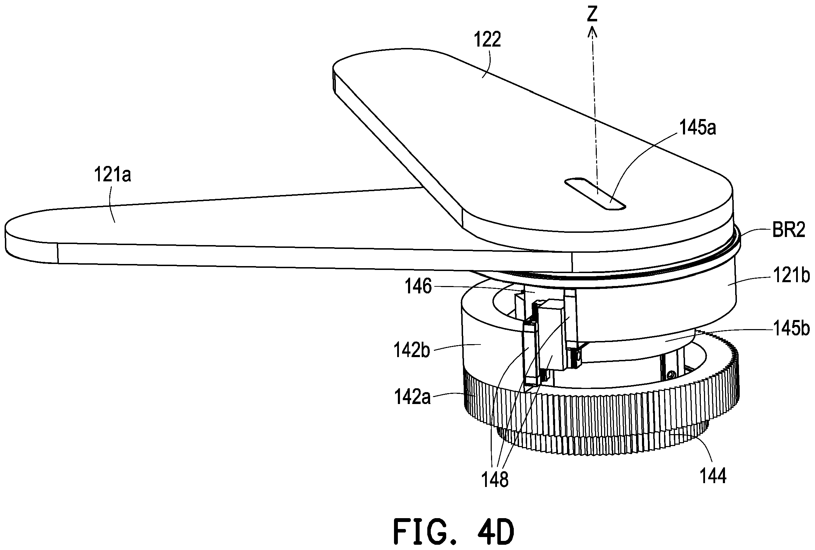

FIG. 4A to FIG. 4D illustrate different movement modes of the common rail handling equipment in simple diagrams. Referring to FIG. 4C and FIG. 4D first, following the previously mentioned components of the rotation assembly 140, the action modes are further described in detail. As mentioned above, the first gear 142 is driven by the first rack 141. Therefore, when the first rack 141 moves along the direction D1 (equivalent to the positive X-axis direction), the first gear 142 may be driven to rotate along the Z-axis (clockwise), and in particular, the first arm 121 may be driven to rotate along the direction D2. On the contrary, when the first rack 141 moves along the direction D3 (equivalent to the negative X-axis direction), the first gear 142 may be driven to rotate (counterclockwise), and in particular, the first arm 121 may be driven to rotate along the direction D4.

On the other hand, the second gear 144 is driven by the second rack 143. Therefore, when the second rack 143 moves along the direction D5 (equivalent to the positive X-axis direction), the second gear 144 may be driven to rotate along the Z-axis (counterclockwise), and in particular, the second arm 122 may be driven to rotate along the direction D6. On the contrary, when the second rack 143 moves along the direction D7 (equivalent to the negative X-axis direction), the second gear 144 may be driven to rotate (clockwise), and in particular, the second arm 122 may be driven to rotate along the direction D8.

In addition, by referring to the components of FIG. 4C and FIG. 4D and the components of FIG. 3C at the same time, it may be clearly seen that since the first rail assembly 146 is assembled between the connecting portion 145b of the first shaft 145 and the second shaft 147, the second gear 144 and the second shaft 147 are integrally formed, while the second arm 122 is connected to the top portion 145a of the first shaft 145, therefore, in addition to enabling the first shaft 145 to move (rise and lower) relative to the second gear 144 along the Z-axis through the first rail assembly 146, the rotation action of the second arm 122 along the Z-axis driven by the second gear 144 is not restricted.

Next, referring to FIG. 4A and FIG. 4B and referring to FIG. 3A or FIG. 3B, in this embodiment, the lifting assembly 150 is a scissor-type linkage mechanism, which includes multiple connecting rods 151, 152, 153, and 154. The connecting rod 151 is pivotally connected to the platform 130 and the second slider SL2, the connecting rod 152 is pivotally connected to the platform 130 and the fourth slider SL4, and the connecting rods 151 and 152 are pivotally connected to each other at their centers. Correspondingly, the connecting rod 154 is pivotally connected to the platform 130 and the second slider SL2, the connecting rod 153 is pivotally connected to the platform 130 and the fourth slider SL4, and the connecting rods 153 and 154 are pivotally connected to each other at their centers. In this way, it is equivalent to one end (connecting rods 151 and 154) of the scissor-type linkage mechanism being pivotally connected to the second slider SL2, and the other end (connecting rods 152 and 153) of the scissor-type linkage mechanism being pivotally connected to the fourth slider SL4. Accordingly, the power and control module CM drives the second slider SL2 and the fourth slider SL4 to move closer to each other to raise the platform 130 (the process from FIG. 4A to FIG. 4B), and the power and control module CM drives the second slider SL and the fourth slider SL4 to move away from each other to lower the platform 130 (the process from FIG. 4B to FIG. 4A).

Furthermore, as shown in FIG. 3A and FIG. 3B, the lifting assembly 150 further includes a third rail assembly 155 assembled between the connecting rods 152 and 153 of the lifting assembly 150 and the platform 130, so that the platform 130 may slide along the rail 110 relative to the lifting assembly 150 through the third rail assembly 155, thereby providing the movement margin required by the scissor-type linkage mechanism during movement.

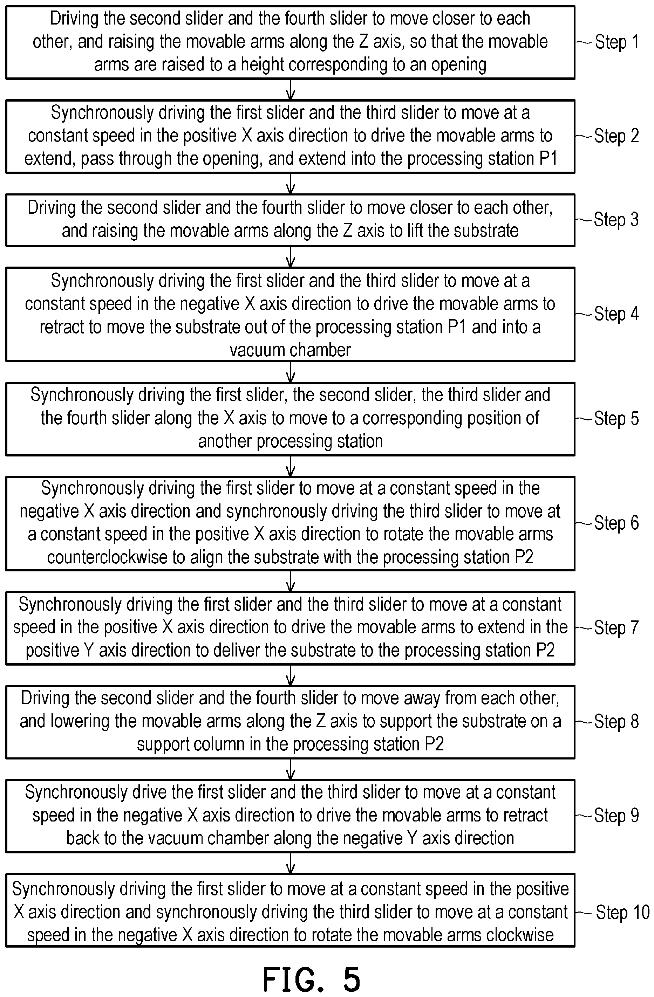

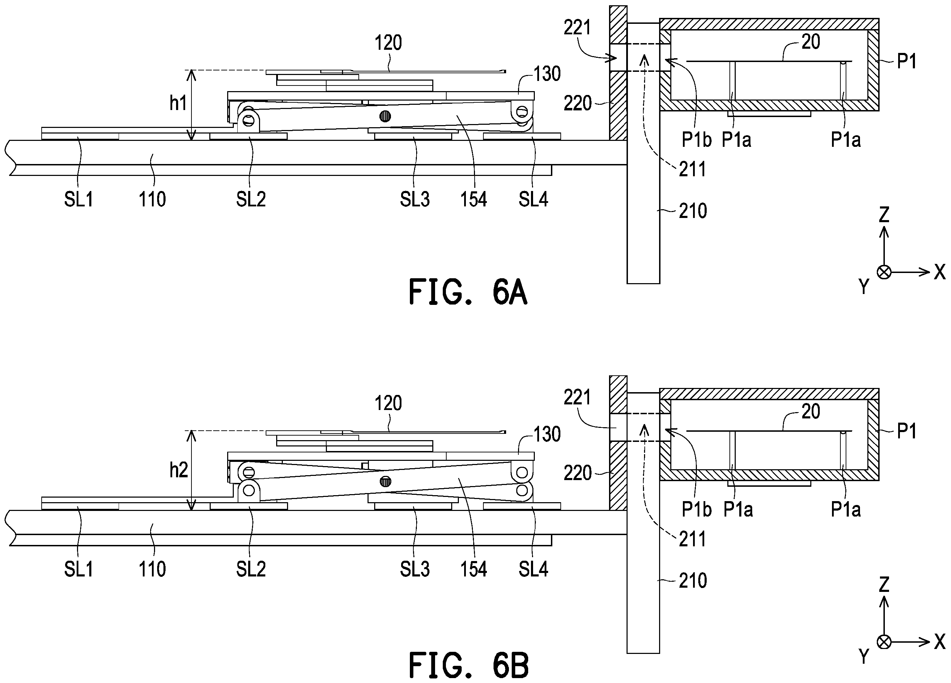

FIG. 5 is an operation flowchart of the common rail handling equipment. FIG. 6A to FIG. 13 are schematic diagrams corresponding to the process of FIG. 5 in different perspectives and different graphics. As mentioned above, the process of this embodiment will be described by taking the common rail handling equipment 100 picking the substrate 20 from the processing station P1 to the vacuum chamber 200, and subsequently transferring it from the vacuum chamber 200 to the processing station P2 as an example.

Referring to FIG. 5, FIG. 6A and FIG. 6B first, firstly, in step 1, the power and control module CM drives the second slider SL2 and the fourth slider SL4 to move closer to each other, and raises the platform 130 and the movable arm 120 along the Z-axis, so that the movable arm 120 is raised to a height corresponding to the openings, that is, from the height h1 shown in FIG. 6A to the height h2 shown in FIG. 6B. The height h2 is greater than the height h1. Here, the openings include the opening P1b of the processing station P1, the opening 211 of the slit valve 210, and the opening 221 of the side plate 220 of the vacuum chamber 200.

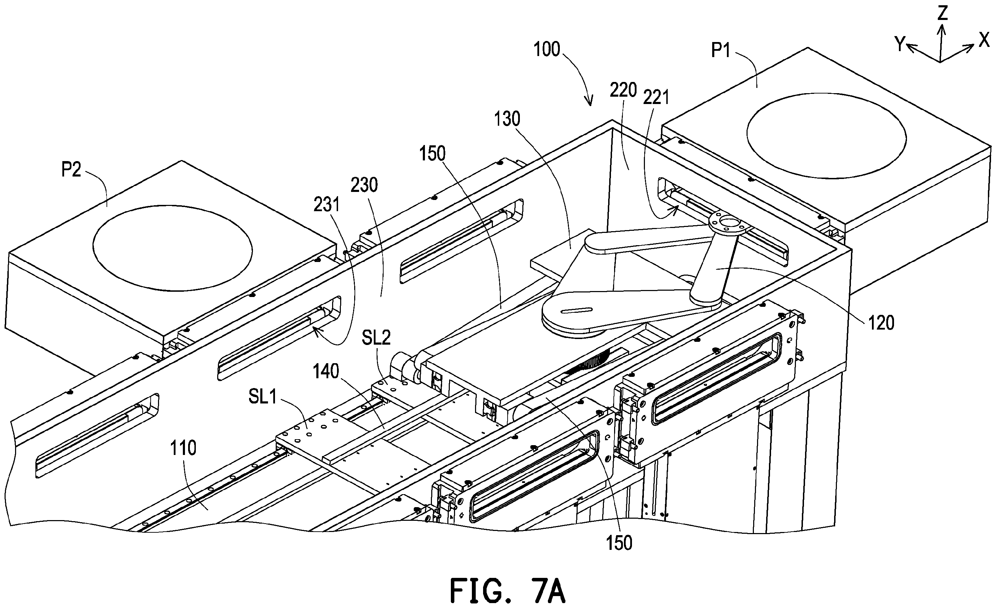

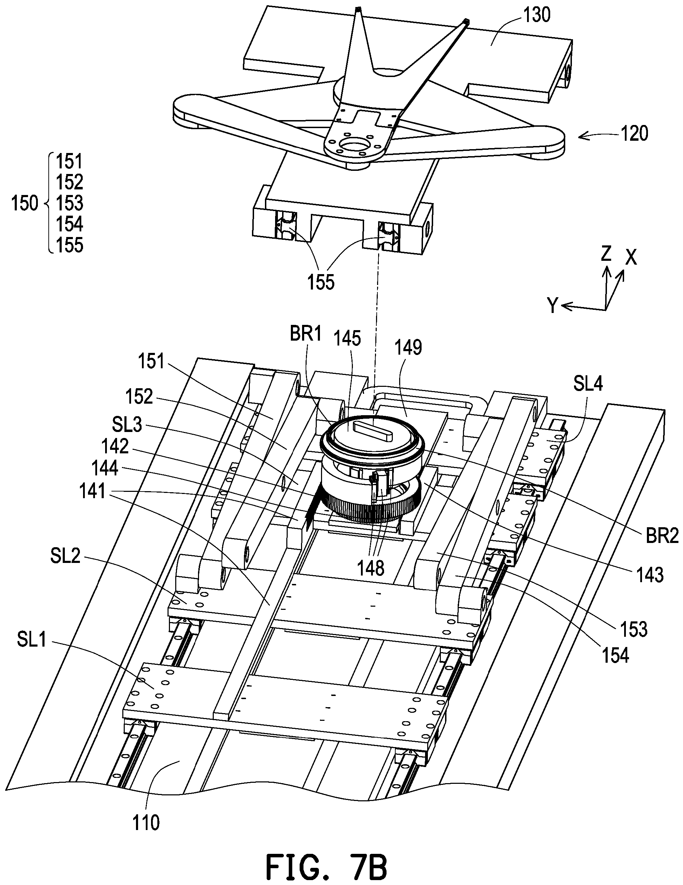

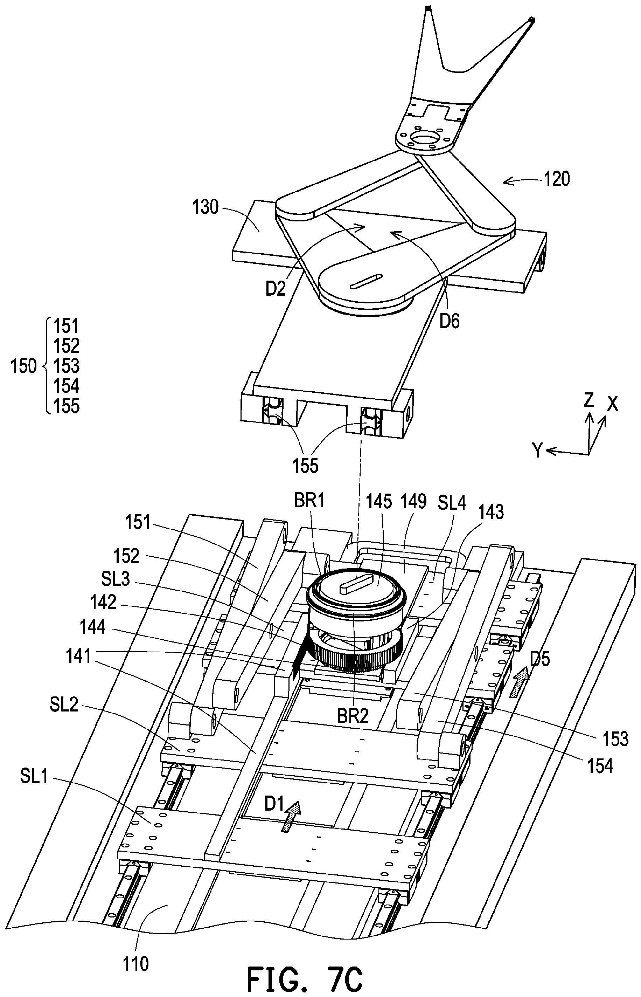

Next, referring to step 2 and referring to FIG. 7A to FIG. 7C, the power and control module CM drives the first slider SL1 and the third slider SL3. The first slider SL1 is moved toward the positive X-axis direction (i.e., the direction D1 as shown in FIG. 4C) to drive the first arm 121 to rotate clockwise (i.e., the direction D2 as shown in FIG. 4C). At the same time, the power and control module CM also moves the third slider SL3 toward the positive X-axis direction (i.e., the direction D5 as shown in FIG. 4C), so as to drive the second arm 122 to rotate counterclockwise (i.e., the direction D6 as shown in FIG. 4C). Here, the direction D1 is the same as the direction D5. In this way, the first arm 121 and the second arm 122 rotate synchronously and in different directions, so that the movable arm 120 may be converted from the position shown in FIG. 7B to the position shown in FIG. 7C. In other words, the power and control module CM of this embodiment drives the first slider SL1 and the third slider SL3 to move synchronously and at a constant speed in the positive X-axis direction (and preferably, during the movement, the first slider SL1 and the third slider SL3 maintain a relative distance from each other), thereby driving the movable arm 120 to extend, so that the movable arm 120 sequentially passes through the openings 221, 211 and P1b and extends into the processing station P1.

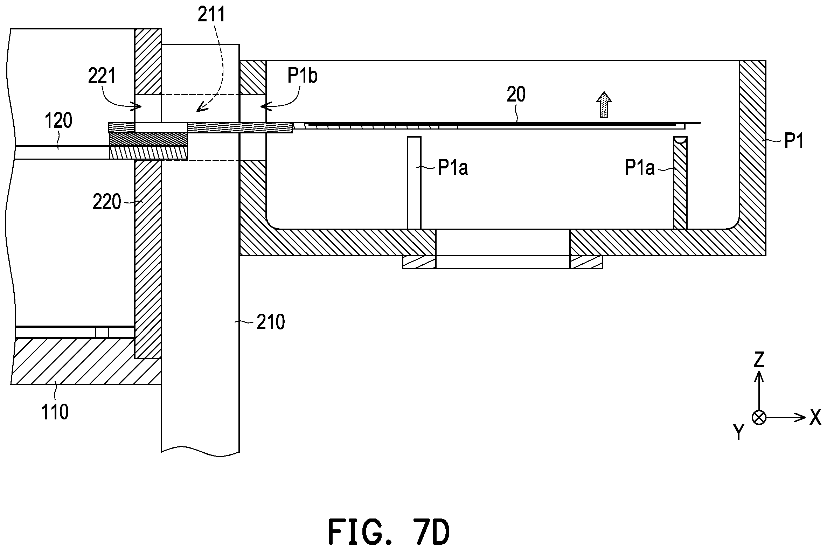

Next, referring to step 3 and referring to FIG. 7D, the power and control module CM drives the second slider SL2 and the fourth slider SL4 to move closer to each other, and the platform 130 and the movable arm 120 are raised along the Z-axis through the lifting assembly 150 thereby lifting the substrate 20.

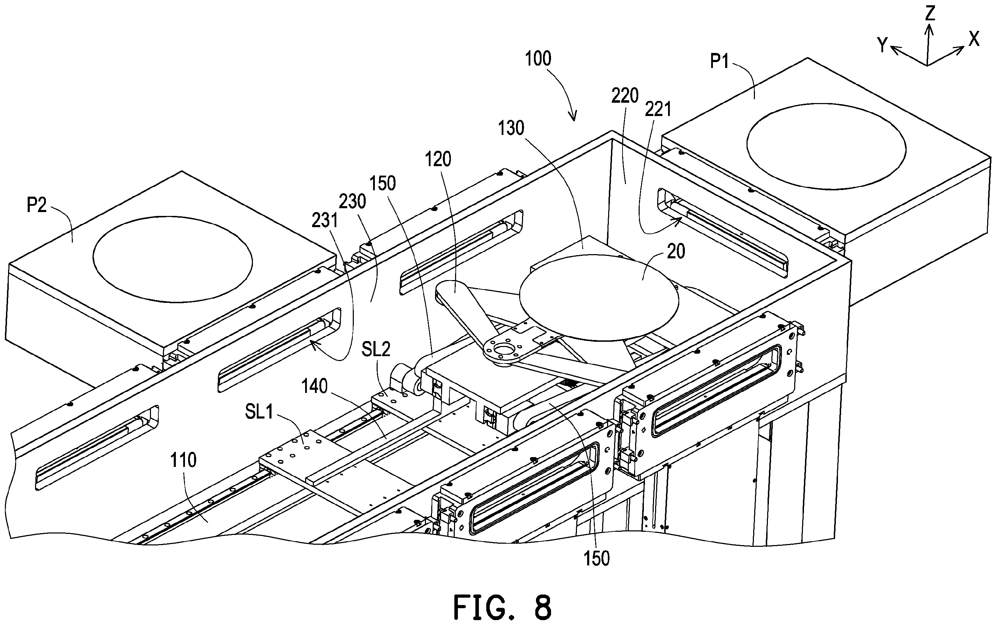

Next, referring to step 4 and referring to FIG. 7A and FIG. 8, the power and control module CM synchronously drives the first slider SL1 and the third slider SL3 to move at a constant speed in the negative X-axis direction to drive the movable arm 120 to retract to move the substrate 20 out of the processing station P1 and into the vacuum chamber 200. Here, reference may also be made to FIG. 7C, that is, the reverse execution of the operation shown in FIG. 7C (also referring to FIG. 4C) is performed to move the first slider SL1 in the direction D3 to drive the first arm 121 to rotate in the direction D4, and at the same time, the third slider SL3 is moved in the direction D7 to drive the second arm 122 to rotate in the direction D8, thereby completing the retraction movement of the movable arm 120 and exiting the processing station P1.

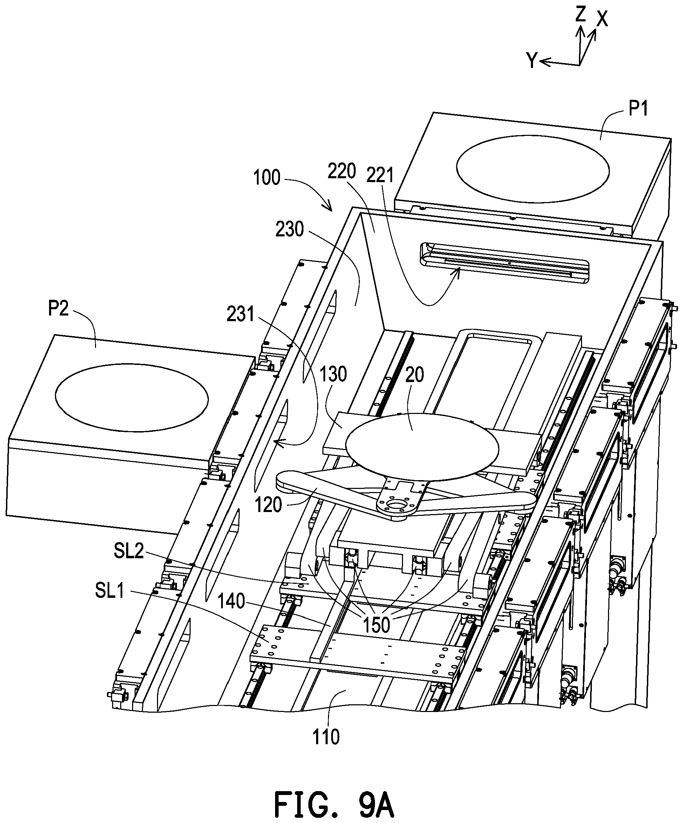

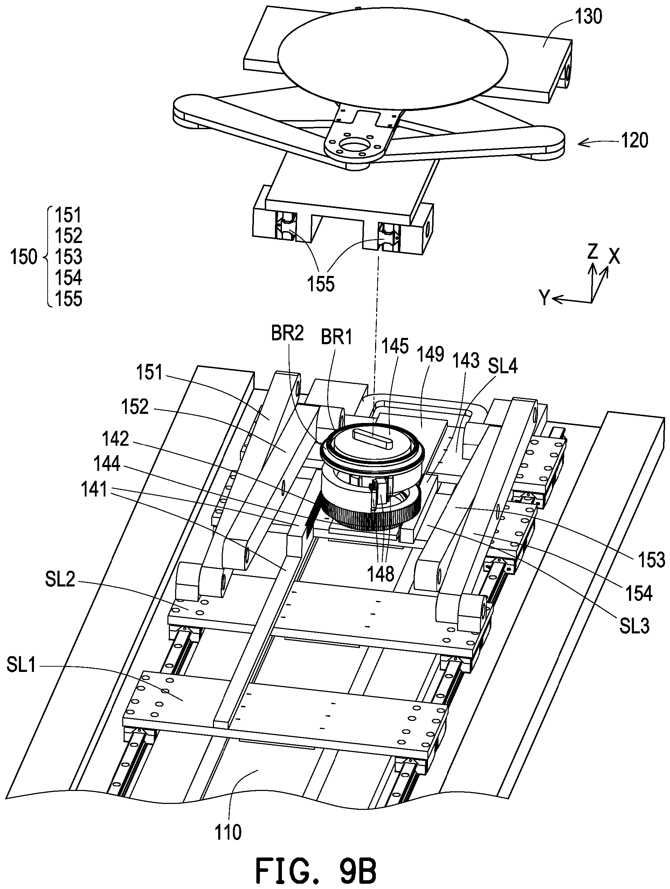

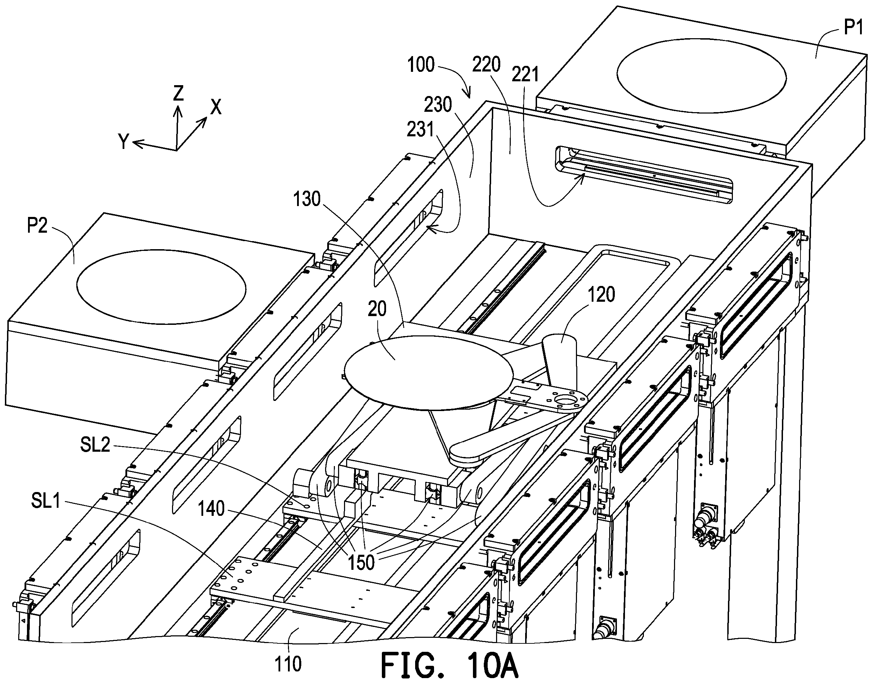

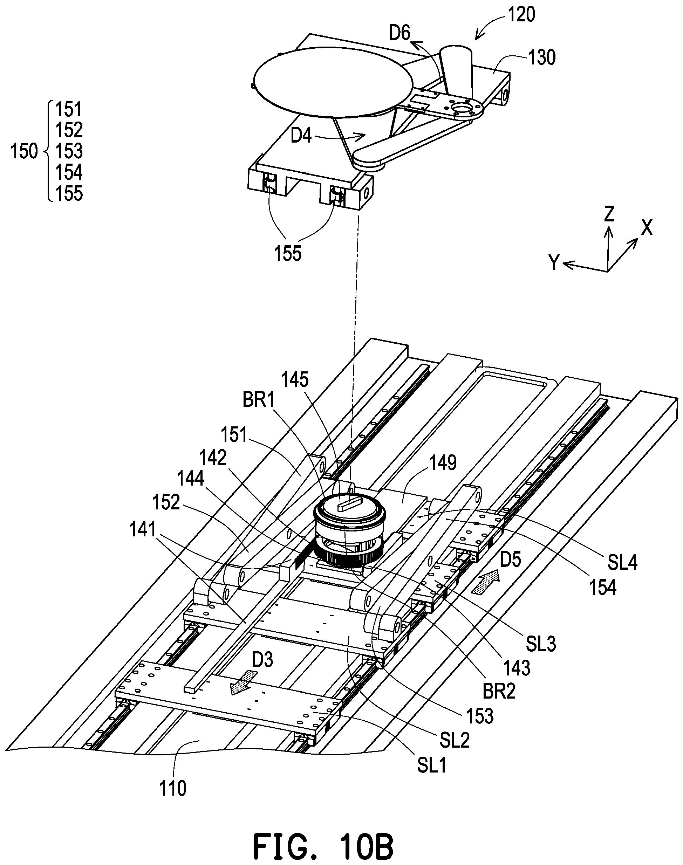

Next, referring to step 5 and referring to FIG. 8, FIG. 9A and FIG. 9B, the power and control module CM synchronously drives the first slider SL1, the second slider SL2, the third slider SL3 and the fourth slider SL4 to move toward the negative X-axis to convert from the position shown in FIG. 8 to the position shown in FIG. 9A. Next, referring to step 6 and referring to FIG. 9A and FIG. 10A, the power and control module CM synchronously drives the first slider SL1 to move at a constant speed in the negative X-axis direction and synchronously drives the third slider SL3 to move at a constant speed in the positive X-axis direction (and preferably, the first slider SL1 and the third slider SL3 maintain a relative distance from each other during the movement), so as to rotate the movable arm 120 counterclockwise to align the substrate 20 with the processing station P2. Referring to FIG. 9B and FIG. 10B at the same time, the action is schematically shown in FIG. 10B. By comparing the diagrams, it may be seen that the power and control module CM drives the first slider SL1 to move along the direction D3 to drive the first arm 121 to rotate along the direction D4, and simultaneously drives the third slider SL3 to move along the direction D5 to drive the second arm 122 to rotate along the direction D6. Here, the direction D4 and the direction D6 are in the same direction (i.e., the aforementioned counterclockwise direction).

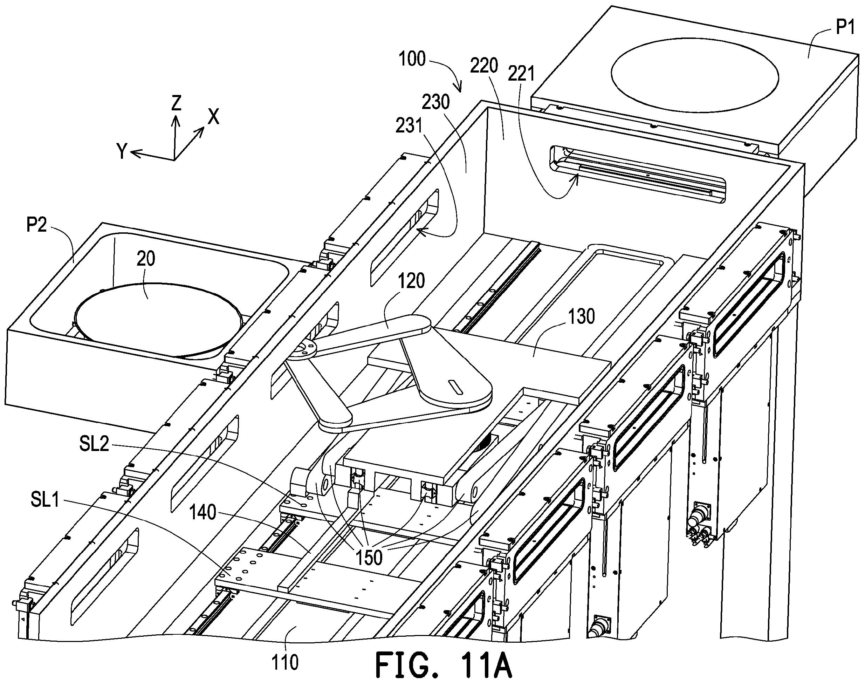

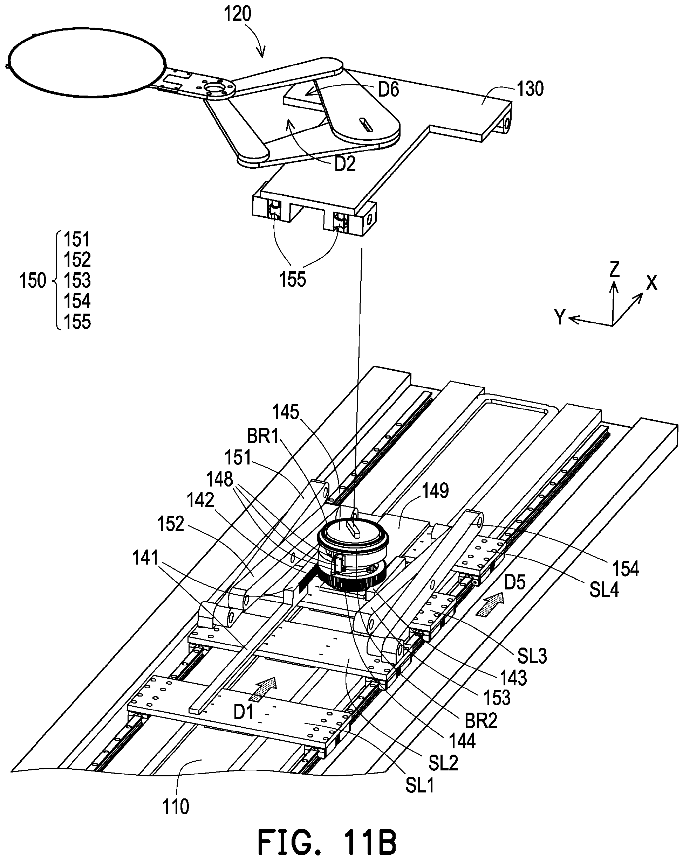

Next, referring to step 7 and referring to FIG. 10A and FIG. 11A, the power and control module CM synchronously drives the first slider SL1 and the third slider SL3 to move at a constant speed in the positive X-axis direction to drive the movable arm 120 to extend along the positive Y-axis direction to transfer the substrate 20 into the processing station P2. Referring to FIG. 10B and FIG. 11B at the same time, the direction of action is shown in FIG. 11B. The power and control module CM drives the first slider SL1 to move along the direction D1 to drive the first arm 121 to rotate along the direction D2, and simultaneously drives the third slider SL3 to move along the direction D5 to drive the second arm 122 to rotate along the direction D6. That is, as shown in the extension action in FIG. 7C, the power and control module CM drives the first slider SL1 and the third slider SL3 to move synchronously and in the same direction, thereby causing the first arm 121 and the second arm 122 to rotate in different directions, and the purpose of extending the movable arm 120 is achieved.

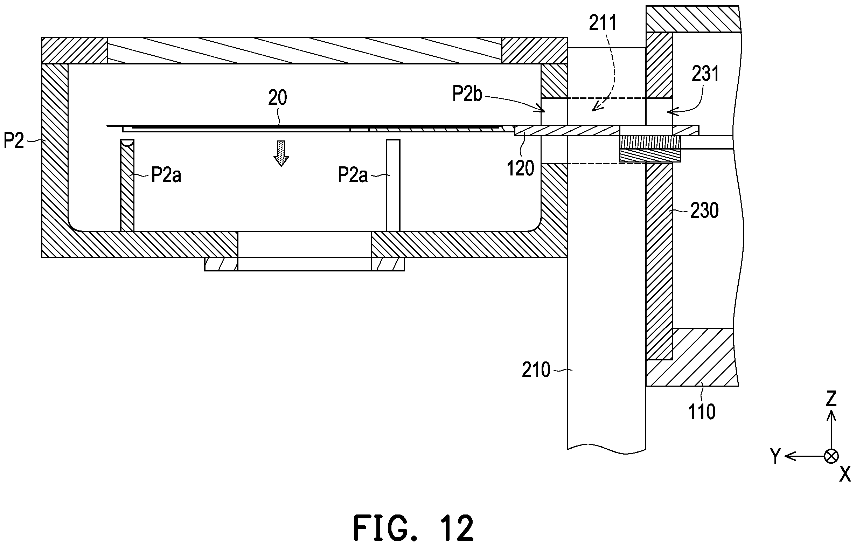

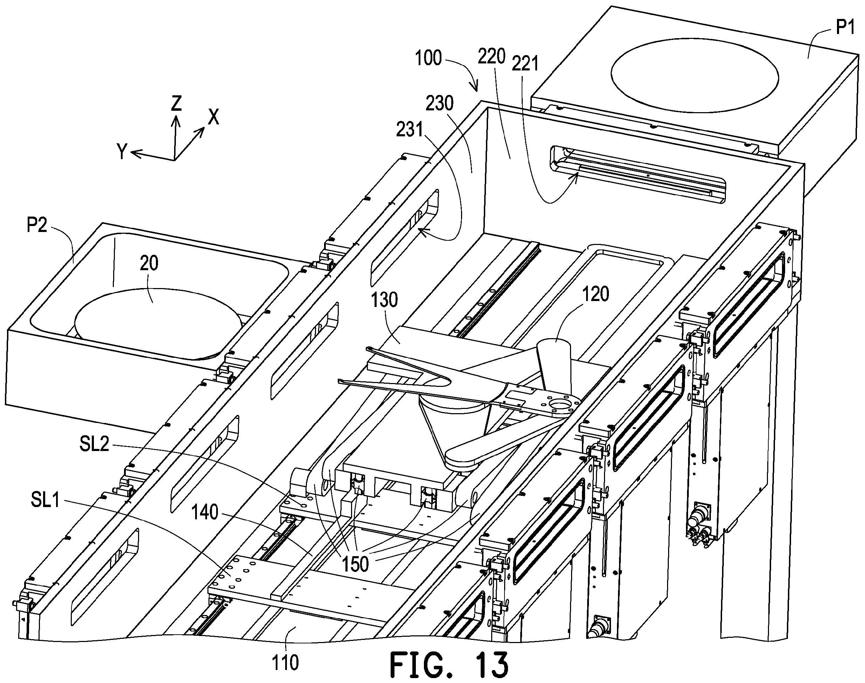

As mentioned above, after the movable arm 120 moves the substrate 20 into the processing station P2 through the openings 231, 211 and P2b sequentially, please refer to step 8 and FIG. 12. The power and control module CM drives the second slider SL2 and the fourth slider SL4 to move away from each other, and lowers the platform 130 and the movable arm 120 along the Z-axis to support the substrate 20 on the support column P2a in the processing station P2. After the substrate 20 is placed, reference may be made to step 9, FIG. 11A and FIG. 13. The power and control module CM may synchronously drive the first slider SL1 and the third slider SL3 to move at a constant speed in the negative X-axis direction to drive the movable arm 120 to retract back to the vacuum chamber 200 along the negative Y-axis direction. The movement shown is the same as the movement described above for converting from FIG. 7A to FIG. 8. At this point, the picking and placing operations of the substrate 20 are completed.

Finally, referring to step 10 and performing the action shown in FIG. 10B in reverse, the power and control module CM synchronously drives the first slider SL1 to move at a constant speed in the positive X-axis direction and synchronously drives the third slider SL3 to move at a constant speed in the negative X-axis direction to rotate the movable arm 120 clockwise. In other words, at this time, the power and control module CM drives the first slider SL1 to move in the direction D1 to drive the first arm 121 to rotate in the direction D2, and drives the third slider SL3 to move in the direction D7 to drive the second arm 122 to rotate in the direction D8. At this time, the direction D2 and the direction D8 are in the same direction (i.e., the clockwise direction mentioned above), and the movable arm 120 is rotated from the positive Y-axis direction back to the positive X-axis direction, and then the movable arm 120 may be driven by the power and control module CM to move to the position shown in FIG. 2A, and the aforementioned step 1 is performed again.

To sum up, in the above-mentioned embodiment of the disclosure, the common rail handling equipment uses a linear guide as a main driving source, in which four sliders are movably disposed on the same rail (single rail). The rail includes multiple electric-magnetic coils arranged linearly, and the sliders each have fixed magnetism. The electric-magnetic coil is powered by the power and control module to generate corresponding magnetic fields, which may respectively drive these sliders of the common rail. Therefore, when the power and control module generates magnetic force through the electric-magnetic coil, it may drive these sliders to slide on the rail.

Furthermore, the common rail handling equipment uses a lifting assembly to pair with the second slider and the fourth slider, and uses a rotation assembly to pair with the first slider and the third slider. In this way, the power and control module may change the sliding mode of the second slider and the fourth slider, thereby completing the lifting and lowering operation of the movable arm by using the lifting assembly. The power and control module may also change the sliding mode of the first slider and the third slider, thereby achieving the rotation and extension or retraction operations of the movable arm by using the rotation assembly. Based on the above motion modes, the movement of a single movable arm may meet the needs of picking up and placing the substrate.

In this way, the aforementioned driving components may be effectively and unobstructedly disposed in the vacuum chamber. In addition to avoiding concerns related to vacuum degree or potential contamination, this approach enables the completion of object transfer within a vacuum environment through the movement operation of a single movable arm.

## Claims

1. A common rail handling equipment (100), comprising:
a linear guide, comprising:
a power and control module (CM);
a rail (110), comprising a plurality of electric-magnetic coils (111) arranged linearly and electrically connected to the power and control module (CM) respectively;
a first slider (SL1), a second slider (SL2), a third slider (SL3), and a fourth slider (SL4), movably coupled to the rail (110) sequentially and respectively having fixed magnetism,
wherein the electric-magnetic coils (111) electrically connected to the power and control module (CM) are powered to generate corresponding magnetic fields to drive and control the first slider (SL1), the second slider (SL2), the third slider (SL3), and the fourth slider (SL4) to slide on the rail (110) respectively;
a platform (130);
a lifting assembly (150), connected to the second slider (SL2), the fourth slider (SL4), and the platform (130), wherein the power and control module (CM) drives the second slider (SL2) and the fourth slider (SL4) to slide on the rail (110), and drives the platform (130) to rise and lower relative to the rail (110) through the lifting assembly (150);
a movable arm (120), movably disposed on the platform (130); and
a rotation assembly (140), disposed on the first slider (SL1), the third slider (SL3), and the platform (130) to connect the movable arm (120), wherein the power and control module (CM) drives the first slider (SL1) and the third slider (SL3) to slide on the rail (110), and drives the movable arm (120) to extend or retract or rotate relative to the rail (110) through the rotation assembly (140).

2. The common rail handling equipment (100) according to claim 1, wherein the rotation assembly (140) comprises:
a first rack (141), fixed on the first slider (SL1); and
a first gear (142), rotatably disposed on the platform (130), wherein the first rack (141) and the first gear (142) are on movement paths of each other.

3. The common rail handling equipment (100) according to claim 2, wherein the rotation assembly (140) further comprises:
a second rack (143), fixed on the third slider (SL3); and
a second gear (144), rotatably disposed on the platform (130), wherein the second rack (143) and the second gear (144) are movably engaged with each other.

4. The common rail handling equipment (100) according to claim 3, wherein the first gear (142) and the second gear (144) are coaxially arranged one above another.

5. The common rail handling equipment (100) according to claim 3, wherein the common rail handling equipment (100) further comprises:
a first shaft (145), assembled to the platform (130), wherein a second arm (122) of the movable arm (120) is connected to the first shaft (145);
a second shaft (147); and
a first rail assembly (146), connected between the first shaft (145) and the second shaft (147), wherein the first shaft (145) is lifted and lowered relative to the second shaft (147) through the first rail assembly (146).

6. The common rail handling equipment (100) according to claim 5, wherein the first gear (142) surrounds the first shaft (145) and the second shaft (147), and the second gear (144) and the second shaft (147) are an integrated structure, so that when the second gear (144) rotates, the second arm (122) is driven to rotate through the second shaft (147), the first rail assembly (146), and the first shaft (145).

7. The common rail handling equipment (100) according to claim 3, wherein the first gear (142) has a tooth portion (142a) that is a ring shape and a driving protrusion (142b) extending from a top surface of the ring shape, the movable arm (120) comprises a first arm (121) pivotally disposed on the platform (130), the first arm (121) has a first arm portion (121a) and a driven protrusion (121b) extending from a bottom surface of the first arm portion (121a), and the driven protrusion (121b) passes through the platform (130) and extends to a rotation path of the driving protrusion (142b), so that when the first gear (142) rotates, the first arm (121) is driven to rotate through the driving protrusion (142b) and the driven protrusion (121b).

8. The common rail handling equipment (100) according to claim 7, wherein the rotation assembly (140) further comprises a second rail assembly (148) disposed between the driven protrusion (121b) of the first arm (121) and the driving protrusion (142b) of the first gear (142), so that the first arm (121) and the first gear (142) rotate synchronously with an axis and slide relatively along the axis.

9. The common rail handling equipment (100) according to claim 7, wherein the movable arm (120) is a scissor-type linkage mechanism, and a second arm (122) of the movable arm (120) is connected to and synchronized with the second gear (144) through a shaft assembly (SA), the first gear (142) is coaxially sleeved outside the shaft assembly (SA) and may rotate relative to each other, the power and control module (CM) drives the first slider (SL1) and the third slider (SL3) to move synchronously in different directions and at a constant speed to drive the movable arm (120) to rotate along an axis, the power and control module (CM) drives the first slider (SL1) and the third slider (SL3) to move synchronously in a same direction and at a constant speed to drive the movable arm (120) to extend or retract.

10. The common rail handling equipment (100) according to claim 1, wherein the lifting assembly (150) is a scissor-type linkage mechanism, one end of the scissor-type linkage mechanism is pivotally connected to the second slider (SL2), another end of the scissor-type linkage mechanism is pivotally connected to the fourth slider (SL4), the power and control module (CM) drives the second slider (SL2) and the fourth slider (SL4) to move closer to each other to raise the platform (130), the power and control module (CM) drives the second slider (SL2) and the fourth slider (SL4) to move away from each other to lower the platform (130).

11. The common rail handling equipment (100) according to claim 1, wherein the first slider (SL1), the second slider (SL2), the third slider (SL3), and the fourth slider (SL4) are respectively permanent magnets (M1) or electromagnets.

12. The common rail handling equipment (100) according to claim 1, wherein the first slider (SL1), the second slider (SL2), the third slider (SL3), and the fourth slider (SL4) are coplanar.

13. The common rail handling equipment (100) according to claim 1, wherein the common rail handling equipment (100) further comprises a second rail assembly (148) assembled between two connecting rods (151, 152, 153, 154) of the lifting assembly (150) and the platform (130), so that the platform (130) may slide along the rail (110) relative to the lifting assembly (150) through the second rail assembly (148).

14. The common rail handling equipment (100) according to claim 1, suitable for being disposed in a vacuum chamber (200) to form a vacuum processing system (10), and a plurality of processing stations (P1, P2) are connected to a periphery of the vacuum chamber (200), wherein a substrate in one of the processing stations (P1, P2) is suitable for being transferred to another one of the processing stations (P1, P2) by the common rail handling equipment (100).
